# EUROPEAN PATENT SPECIFICATION

(11) **EP 2 025 014 B1**
(45) Date of publication and mention of the grant of the patent: **18.11.2009**
(21) Application number: 07794555.8
(22) Date of filing: 04.05.2007
(51) Int. Cl.: H01L 51/05

(54) **PENTACENE POLYMERS AND THEIR USE IN ELECTRONIC DEVICES**
PENTACENPOLYMERE UND IHRE VERWENDUNG FÜR ELEKTRONISCHE GERÄTE
POLYMÈRES DE PENTACÈNE ET LEUR UTILISATION DANS DES DISPOSITIFS ÉLECTRONIQUES

(30) Priority: 05.05.2006 US 381771
(43) Date of publication of application: 18.02.2009
(73) Proprietor: LUCENT TECHNOLOGIES INC., Murray Hill NJ 07974-0636 (US)
(72) Inventor: LIU, Sen, Highland Park, NJ 08904 (US); SYDORENKO, Oleksandr, Painted Post, NY 14870 (US); VAIDYANATHAN, Subramanian, New Providence, NJ 07974 (US)
(74) Representative: Nicolle, Olivier
(86) International application number: PCT/US2007/010830
(87) International publication number: WO 2007/130570

(56) References cited:
- WO-A-00/31208
- WO-A-01/45469
- WO-A-2006/125504
- JP-A- 2005 109 337
- US-B1- 6 690 029
- SAKAMOTO Y ET AL: "PERFLUOROPENTACENE AND PERFLUOROTETRACENE: SYNTHESES, CRYSTAL STRUCTURES, AND FET CHARACTERISTICS" MOLECULAR CRYSTALS AND LIQUID CRYSTALS SCIENCE AND TECHNOLOGY. SECTION A. MOLECULAR CRYSTALS AND LIQUID CRYSTALS, GORDON AND BREACH PUBLISHERS, CH, CH, vol. 444, no. 1, February 2006 (2006-02), pages 225-232, XP008079716 ISSN: 1058-725X
- INOUE Y ET AL: "ORGANIC THIN-FILM TRANSISTORS WITH HIGH ELECTRON MOBILITY BASED ON PERFLUOROPENTACENE" JAPANESE JOURNAL OF APPLIED PHYSICS, JAPAN SOCIETY OF APPLIED PHYSICS, TOKYO, JP, vol. 44, no. 6A, June 2005 (2005-06), pages 3663-3668, XP001502316 ISSN: 0021-4922

## Description

### TECHNICAL FIELD OF THE INVENTION

The invention relates to new organic semiconductors and active devices that include such materials.

### BACKGROUND OF THE INVENTION

There is great interest in the development and use of organic electronic materials as alternatives to silicon-based semiconductors. Pentacene has among the highest mobilities of acenes and other organic molecules that may be used as organic semiconductors. As well known to those of ordinary skill in the art acenes are polycyclic aromatic hydrocarbons consisting of fused benzene rings in a rectilinear arrangement.

JP 2005 109337 describes an organic semiconductor layer comprising pentacene monomers linked together through a linkage group.

However, the insolubility of acenes, such as pentacene, and their susceptibility to oxidation limit their application. Additionally, the low solubility means that relatively expensive vapor deposition techniques instead of solution processes must be used to form thin films of these compositions.

Y. Inoue, Y. Sakamoto, T. Suzuki, M. Kobayashi, Y. Gao, S. Tokito, Jpn. J. Appl. Phys. 44 (2005) 3663-3668; WO 01/45469; US-6 690 029; WO 00/31208; and WO 2006/125504 relate to compositions including pentacene or a pentacene derivative, but do not disclose the composition claimed in the present invention.

### SUMMARY OF THE INVENTION

One embodiment is a composition, comprising a polymer of a plurality of monomers, each monomer being pentacene or a substituted pentacene, and at least two of the monomers being covalently bonded to each other by a bridging subunit, wherein said bridging subunit comprises at least one electron-withdrawing group.

Still another embodiment is an apparatus as defined according to claim 4.

Yet another embodiment is a method as defined according to claim 9.

### BRIEF DESCRIPTION OF THE DRAWINGS

The invention is best understood from the following detailed description, when read with the accompanying FIGUREs. Various features may not be drawn to scale and may be arbitrarily increased or reduced in size for clarity of discussion. Reference is now made to the following descriptions taken in conjunction with the accompanying drawings, in which:
Fig. 1 presents a cross-sectional view of an exemplary embodiment of an apparatus comprising an OFET device;
Fig. 2 presents a cross-sectional view of an exemplary embodiment of an apparatus comprising an OLED device; and
Fig. 3 presents a flow diagram showing selected steps in an exemplary method of manufacture.

### DETAILED DESCRIPTION

While pentacene precursors that can be solution deposited as films and then converted to pentacene have been demonstrated, few attempts to stabilize the molecule have been made previously. Derivatization of pentacene with alkylsilyl groups has shown that the stability can be improved. This notwithstanding, the stability of these molecules, especially as thin films, is still poor. Moreover, thin films of pentacene are brittle and therefore are not ideally suited for use in flexible devices.

Presented are novel compositions of acene polymers and substituted acenes. The polymers are formed of monomers of acene or substituted acene. The polymers are expected to produce layers that are less brittle than layers made of the non-polymeric acene monomer. The acene polymers or substituted acenes can have electron-withdrawing substitutions. For that reason, the acene polymers or substituted acenes can be less susceptible to degradation via oxidation in air than the unsubstituted acene. The acene polymers or substituted acenes can also have solubilizing groups. Because these acene polymers or substituted acenes are more soluble in organic solvents, films comprising these molecules can be deposited using solution deposition processes. Consequently, an apparatus that includes these compositions is expected to have improved operating characteristics or longevity, or to be more easily fabricated.

One embodiment is a composition. The composition comprises a plurality of molecules, each molecule comprising two or more acenyl subunits. The molecules have a lower oxidation rate than an acene molecule having a same chemical composition as the acenyl subunit and measured under the same environmental conditions (*e.g*., under ambient light and air saturated solutions). For example, if the acenyl subunit comprises a pentacenyl group, then the molecule has a lower oxidation rate than pentacene. One of ordinary skill in the art would be familiar with conventional methods to measure the oxidation rate of organic molecules. For example, one could measure the rate of change in the ultraviolet or visible absorption spectrum of the acenyl-containing molecule over time and compare this to the rate of change of the parent acene molecule.

The plurality of molecules of the above described composition can be characterized by the general formula:

- (A-B) ₘ- (1)

where m ≥ 1, "A" comprises the acenyl subunit: 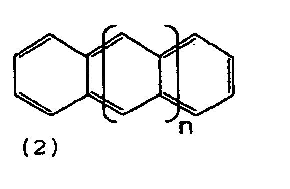 where n = 1, 2, 3 ... and "B" comprises the bridging subunit. As indicated by structure (1), the acenyl subunits and bridging subunit can be repeated m times to form an oligomer or polymer.

For example, some preferred embodiments of the composition comprise molecules having at least two acenyl subunits (*e.g*., m ≥ 2) that are covalently bonded to each other by a bridging subunit, wherein, the bridging subunit comprises at least one electron-withdrawing group and optionally an aditional solubilizing group. In other preferred embodiments the molecule is a polymer having at least 10 repeats of the acenyl subunit (*e.g*., m ≥ 5).

The acenyl-subunit can be any polycyclic aromatic hydrocarbon consisting of fused benzene rings in a rectilinear arrangement. The benzene rings can be derivatized. For example, one or more of the carbon atoms of the fused benzene rings can be substituted with halogen atoms, such as fluorine. As another example, one or both of the end benzene rings of the acenyl subunit can be derivatized by being fused to thiophene rings to form, *e.g.*, a dithiophene acenyl subunit: 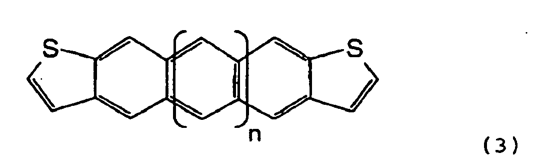 Some preferred dithiophene acenyl groups include anthradithiophene (*e.g*., n=1 in formula (3)) and pentadithiophene (*e.g*., n=3 in formula (3)).

For the purposes of the present invention, an electron-withdrawing group is any organic substitutent that causes the molecule to have a lowest unoccupied molecular orbital (LUMO) energy level that is lower than the LUMO energy level of the individual acene molecule. The electron withdrawing group, also know as electron acceptors, tend to withhold electrons through either inductive or resonance mechanisms. While not limiting the scope of the invention by theory, it is thought that lowering the LUMO energy level of the molecule makes it less susceptible to oxidation. One of ordinary skill in the art would be familiar with the conventional techniques to determine the LUMO energy level of molecules. Examples of such techniques include cyclic voltammetry, ultraviolet photoelectron spectroscopy, x-ray photoelectron spectroscopy, or combinations thereof. Non-limiting examples of some preferred electron withdrawing groups include oxadiazole groups, carbonyl groups and halogen-substituted rings, such as perfluorinated aromatic rings, trifluoro-substituted aromatic rings, or trifluoromethyl-substituted aromatic rings.

For the purposes of the present invention, a solubilizing group is defined as any organic substitutent that causes the molecule to have a solubility in an organic solvent that is greater than the solubility of the individual parent acene molecule in the same organic solvent. In some cases, the solubilizing group comprises a non-aromatic hydrocarbon group because the presence of an aromatic group is thought to decrease the solubility of the molecule. Suitable aliphatic hydrocarbon groups can include alkyl, alkoxyl, alkenyl, alkynyl, or cyclic aliphatic groups. The hydrocarbon group can be halogenated, and could be a branched or linear chain. In some preferred embodiments, the non-aromatic hydrocarbon group comprises an alkyl or alkoxy group having between 6 and 20 carbon atoms, and more preferably, between 8 and 16 carbon atoms. Non-limiting examples include linear or branched octyl, nonyl, decyl, undecyl and dodecyl alkyl groups.

The acenyl subunit can be substituted at any available carbon position in the fused benzene rings. In some cases the substitution chemically bonds a bridge subunit to any available carbon position in the fused benzene rings of the acenyl subunits. In some preferred embodiments, each of the acenyl subunits has an odd number of fused benzene rings (*e.g*., n = 1, 3, 5,...). An odd number of benzene rings is preferred in certain cases where it is desirable to introduce symmetric substituents into the acene ring. In addition, regioregular molecules are obtained when the acenyl subunits have an odd number of fused benzene rings and symmetric substitutions are made.

Consider, as an example, the case when the acenyl subunits comprise pentacenyl groups. The pentacenyl groups can have symmetric substitutions, *e.g*., in the 6 and 13 carbon-positions. In other cases, the pentacenyl groups can be substituted in the 5 and 14 positions. Middle-carbon substitutions in the 6 and 13 positions of pentacenyl subunits (or *e.g.*, the 5 and 10, or 7 and 16 positions of anthracenyl or heptacenyl subunits, respectivly) are also advantage when the substituent is an electron-withdrawing group. Substitutions of an electron-withdrawing group in these positions facilitate the electron withdrawing group's effect on the electron density of the acenyl subunit. This, in turn, maximizes the effect of the electron withdrawing group on the LUMO energy level of the molecule.

In some cases, the bridging subunit is symmetrically attached to the acenyl subunits. Continuing with the same example of when the acenyl subunits comprise pentacenyl groups, the bridging subunit can be bonded to the 6 or 13 positions of pentacenyl groups to covalently bond two pentacenyl subunits together. Of course, asymmetric attachments, such as in the 5 or 14 positions of the pentacenyl groups, are also possible.

As noted above, the bridging subunit can comprise at least one of an electron-withdrawing group or a solubilizing group. In some preferred embodiments, however, the bridging subunit comprises both an electron-withdrawing group and a solubilizing group.

In some cases, the bridging subunit comprises an electron-withdrawing group with a solubilizing group chemically bonded thereto. Continuing with the example of when the molecule comprises pentacenyl subunits, the bridging subunit can comprise an electron-withdrawing group of phenyl-1,3,4-oxadiazole: 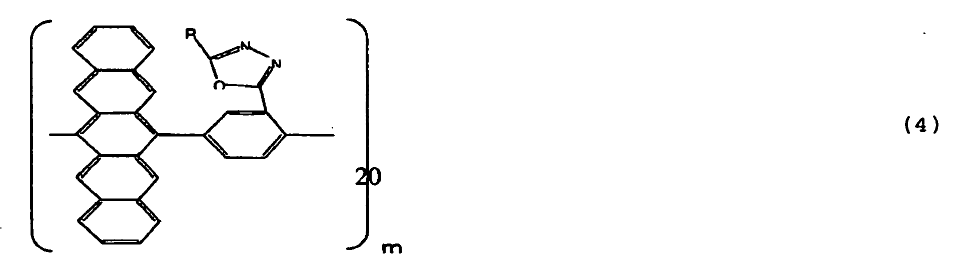 where m ≥ 1, R is a solubilizing group, comprising, *e.g*., a non-aromatic hydrocarbon, such as discussed above. In this example the solubilizing group (R) is covalently bonded to the 5 position of the oxadiazole ring. In other embodiments, however, one or more solubilizing groups could be additionally or alternatively bonded to the phenyl ring of the phenyl-1,3,4-oxadiazole.

In other cases, the bridging subunit can .further comprise a linker group that covalently bonds one or more electron-withdrawing group to at least one of the acenyl subunits. The linker group can comprise an aromatic or nonaromatic hydrocarbon. When the linker group comprises a nonaromatic hydrocarbon, the linker group can also be the solubilizing group. Continuing with the example of when the molecule comprises pentacenyl subunits, and the bridging subunit comprise an electron-withdrawing group of phenyl-1,3,4-oxadiazole. The molecule can also have a linker group which is the solubilizing group (R) of *e.g*., non-aromatic hydrocarbons (m ≥ 1):

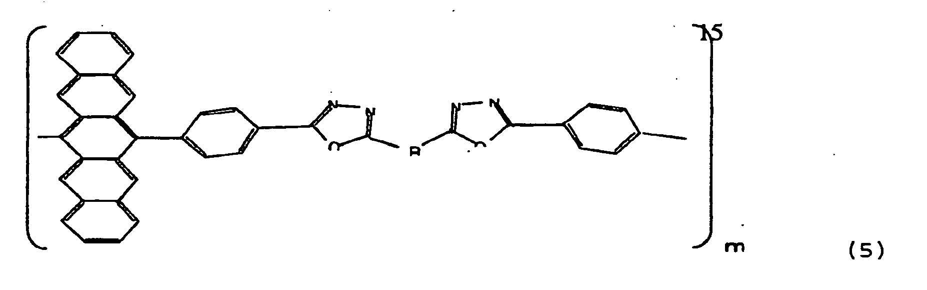

In still other cases, when the bridging subunit further comprises a linker group that comprises aromatic hydrocarbons, the solubilizing group can be attached to the electron-withdrawing group such as present for structure (3) above. Alternatively, the solubilizing group can be attached to the aromatic linker group. Consider again the example of where the molecule comprises pentacenyl subunits and the bridging subunit comprises an electron-withdrawing group of phenyl-1,3,4-oxadiazole. The molecule can comprise a linker group comprising aromatic hydrocarbons such as a stilbene, *e.g*., trans-1,2-diphenylethylene (m ≥ 1): 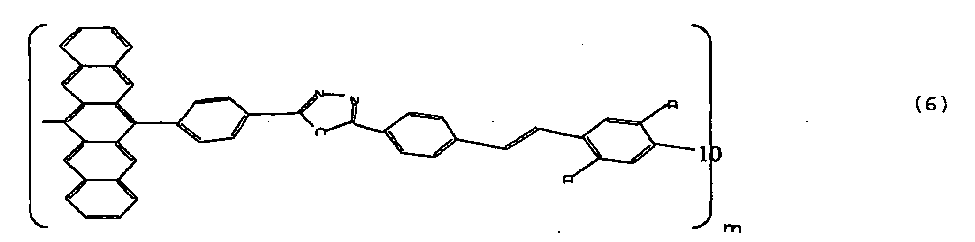 Of course, in other embodiments, the stilbene can be *cis-*1,2-diphenylethylene. As illustrated for structure (6), two of more solubilizing groups, R, can be attached to the linker group, for example, to a phenylene group of the stilbene linker group. One skilled in the art would appreciate that the solubilizing groups could be attached to different carbons of the linker groups or to both the linker group and the electron withdrawing group.

In some preferred embodiments, the pi-electrons of the electron-withdrawing group are conjugated to the pi-electrons of at least one of the acenyl subunits. For example, for structure (5), the conjugation is expected to extend from the pentacenyl subunit to the phenyl-1,3,4-oxadiazole that is bonded to that pentacenyl subunit. Extending pi-pi conjugation lengths in this manner is thought to increase the field effect mobility of the molecule when used as the semiconductor channel in an active device. For example, extending the conjugation length of anthracenyl or tetracenyl subunits are expected to significantly increase the mobility of the molecule as compared to anthracene or tetracene, respectively. Of course, as well understood by those skilled in the art, other factors, such as the morphology of the thin film semiconductor will also have important effects on mobility.

More preferably the electron-withdrawing group and linker group, if present, extends the conjugation between adjacent acenyl subunits. For example, as illustrated for structures (4) and (6), the conjugation is expected to extend from one pentacenyl subunit through the bridge subunit and to the second pentacenyl subunit. One of ordinary skill in the art would understand how to estimate the average conjugation length of the molecules, for example, based on their ultraviolet/visible and fluorescent spectroscopic properties.

Another embodiment is a composition that comprises a polymer of a plurality of monomers, each monomer being pentacene or a substituted pentacene. For instance, in the context.of formulas (1) and (2), m ≥ 2 and n = 5. In some preferred embodiments, the polymer comprises at least 10 of the monomers. The monomers can be covalently joined together via any conventional bridging subunit, including, but not limited to, the bridging subunits presented above.

In some cases, at least some of the monomers can include a substituted pentacene. Here, a substituted pentacene has a substitution on one or more of the fused benzene rings of the pentacenyl group other than the substitutions needed to make a pentacene polymer. For example, one or more of the carbon atoms of the fused benzene rings can be bonded to a halogen atom substituent, such as fluorine. As another example, each substituted pentacene can include a pentacene unit and an electron-withdrawing group chemically bonded to the pentacene unit. The electron-withdrawing group need not participate in the bridging subunit, although, in some cases it may. In some preferred embodiments, the electron-withdrawing group comprises an oxadiazole group, such as 2-phenyl-1,3,4-oxadiazole. In other cases, a solubilizing group comprising a hydrocarbon chain is bonding to the oxadiazole group, for example, at the 5 position of the oxadiazole ring of the 2-phenyl-1,3,4-oxadiazole. More preferably, two oxadiazole groups are chemically bonded to the pentacene unit at the 6 and 13 positions. Exemplary molecules include 6,13-bis(2-phenyl-1,3,4-oxadiazole)pentacene and 5,14-bis(2-phenyl-1,3,4-oxadiazole)pentacene.

One of ordinary skill in the art would be familiar with methods to synthesize and purify the above-described molecules. Exemplary conventional synthetic reactions that could be adopted to synthesize these molecules are presented in: Anthony et al., J. Am. Chem. Soc. 2003, 123, 9482-83, and Vets et al., Synlett 2005, No. 2, 217-222, both of which are incorporated by reference in their entirety.

As an example, one possible synthetic route to produce structures (4), (5) and (6) involves lithiating a dibrominated precursor and reacting this with a pentacene quinone (*e.g*., 6,13 pentacenediquinone), by a nucleophilic addition. Reduction of the product of this reaction then gives the desired molecule. To form structure (4), for example, the dibrominated precursor can be a 2-(2, 5 dibromophenyl)-1,3,4-oxadiazole:

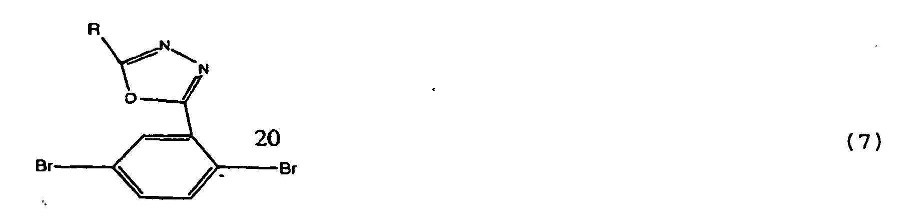

In analogous fashion, other dibrominated precursors can be used in the formation of structure (5): 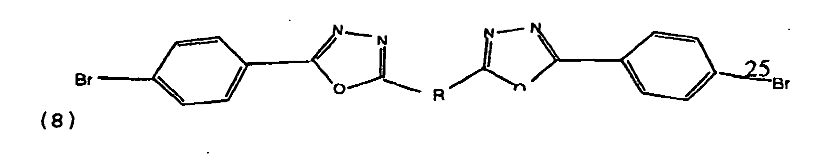 or in the formation of structure (6): 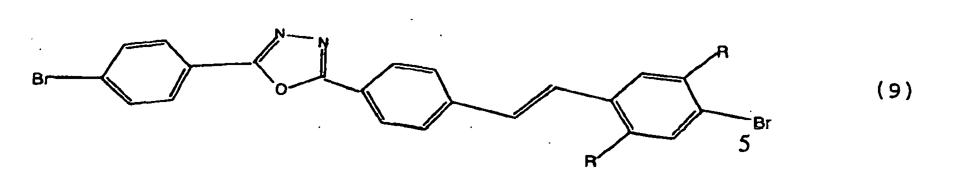 In some embodiments, it is possible to have more than one aromatic linking group with *e.g*., alkyl solublizing groups attached thereto per bridging unit. In still other embodiments, a mono-brominated precursor can be used to form a substituted pentacene. One of ordinary skill in the art would be familiar with the procedures and conditions to carry out the lithiation, nucleophilic addition, and reduction reactions.

Another embodiment is an apparatus. The apparatus comprises a matrix (*e.g*., a layer) composed of a plurality of any of the above-described molecules.

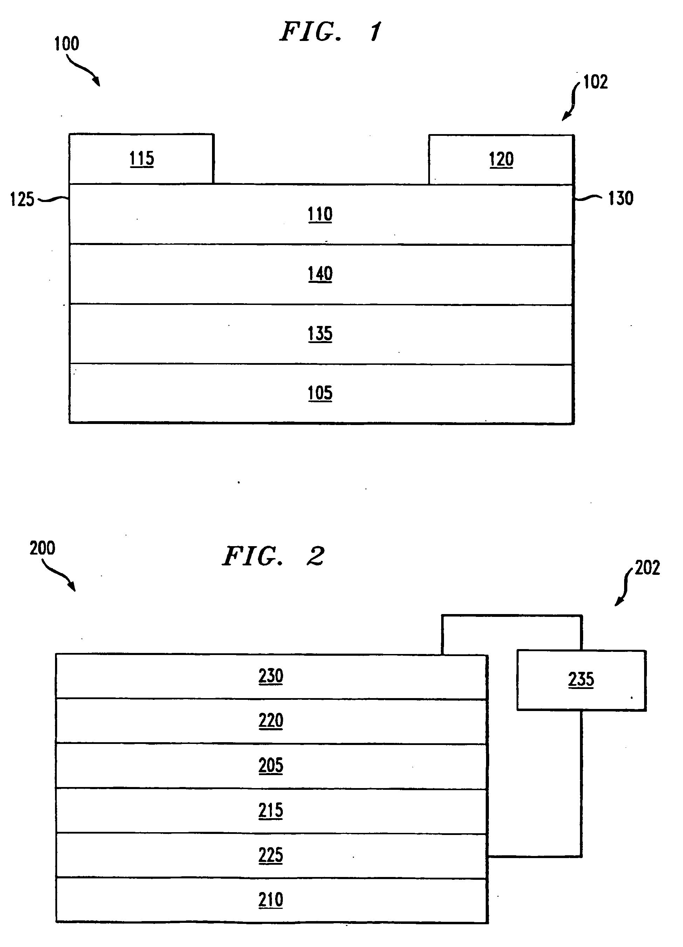

Fig. 1 presents cross-sectional views of an exemplary embodiment of an apparatus 100 that includes an active device such as an organic field effect transistor (OFET) 102. The apparatus 100 can be used in any number of applications, such as biosensors, integrated circuits, displays, logic devices and memory devices.

The OFET 102 comprises a substrate 105 and an organic semiconductor matrix 110, that functions as a channel, being located over the substrate 105. The organic semiconductor matrix 110 comprises one of a polymer or a stabilized pentacene.

The stabilized pentacene has a lower oxidation rate than pentacene. In preferred embodiments, the stabilized pentacene includes electron-withdrawing groups chemically bonded to a pentacene unit. For example, the stabilized pentacene can comprise 6,13-bis(2-phenyl-1,3,4-oxadiazole)pentacene or 6-(2-phenyl-1,3,4-oxadiazole)pentacene.

The polymer includes monomers of pentacene or a substituted pentacene. In some cases, each of the monomers comprise one pentacenyl subunit that is covalently bonded to a bridging subunit, the bridging subunit comprising at least one of an electron-withdrawing group or a one solubilizing group. As explained above, the bridging subunit can comprise both an electron-withdrawing group and a solubilizing group, or more than one of such groups. Exemplary polymers include at least 10 of the monomers. In certain preferred embodiments, the polymer has a lower oxidation rate than pentacene.

In some cases, the organic semiconductor matrix 110 has a half-life that is at least two times greater than an organic semiconductor channel made of pentacene, measured *e.g*., under ambient light conditions and in an air-saturated solution of the molecules. The half-life can be measured by any number of techniques sensitive to oxidation-induced changes in the molecules of the organic semiconductor 110. For example, one can determine a half-life by measuring the time dependent changes in the absorbance of a ultra-violet or visible absorption band of the polymer or stabilized pentacene. *See e.g.,* Maliakal et al., Chem Mater. 2004, 16, 4980-86, incorporated by reference herein in its entirety. This half-life can then be compared to the half-life of pentacene measured in the same manner and under the same environmental conditions.

In some preferred embodiments, organic semiconductor matrix 110 can be a p-type or n-type semiconductor. For example, when a p-type semiconductor is desired, the matrix can comprise molecules such as presented in the context of structures (1) - (6). When an n-type semiconductor is desired, the molecules of the organic semiconductor matrix 110 can comprise acenyl or bridging subunits that are substituted with one or more of a fluorine or fluorocarbon group. For example, the pentacene monomers or stabilized pentacene can be fluorine or fluorocarbon substituted.

The various components of the OFET 102 can comprise any conventional material well known to those skilled in the art. For example, the substrate 105 can be made of silicon or flexible organic materials such as plastics, for example polyethylene terephthalate (PET), polyethylene napthalate (PEN), or various polyamides.

The OFET 102 can further include first and second electrodes 115, 120 in contact with opposite ends 125, 130 of the organic semiconductor matrix 110. The source and drain electrodes 115, 120 can comprise *e.g.,* gold or other electrically conductive metals or non-metals, such as electrically conductive polymers.

The OFET 102 shown in Fig. 1 can further includes a bottom gate 135 and a gate dielectric layer 140. The bottom gate 135 can comprise doped silicon. In other cases materials more conducive to forming a flexible device, such as indium tin oxide (ITO), can be used. Similarly, the gate dielectric 140 can comprise silicon dioxide, or more flexible materials, such as polymer dielectrics like polybutyl methacrylate (PBMA).

The OFET 102 presented in Fig. 1 is a top contact bottom gate OFET device. However, one of ordinary skill in the art would understand that the OFET 102 could have other conventional configurations, such as a bottom contact OFET device or top gate OFET devices, and the apparatus 100 could comprise a plurality of such devices.

Fig. 2 presents a cross-sectional view of an exemplary embodiment of an apparatus 200 that includes an active device such as an organic light emitting diode (OLED) 202. One of ordinary skill in the art would readily appreciate how the below-described components could be configured to form an organic photovoltaic device instead of an OLED.

The OLED 202 shown in Fig. 2 has an organic semiconductor matrix 205 that functions as a light emitting junction. The organic semiconductor matrix 205 can comprise any of the above-described compositions. For instance, the organic semiconductor matrix 205 can include one of a polymer or a stabilized pentacene. In other instances, the organic semiconductor matrix 205 can include molecules comprising two or more acenyl subunits, which in some cases are covalently linked together with a bridging-subunit.

The OLED 202 as illustrated in Fig. 2 can further include a number of conventional components such as a substrate 210, hole injection layer 215, electron transport layer 220, and cathode and anode 225, 230 electrically connected to a voltage source 235. These components can comprise any conventional material well known to those skilled in the art. For example, the substrate 210 can comprise glass, the hole injection layer 215 can comprise polyethylenedioxythiophene: poly(styrenesulfonate), the electron transport layer 220 can comprise tris-8-hydroxyquinoline aluminum and the cathode and anode 230, 225 can comprise conductive materials, such as aluminum or ITO respectively.

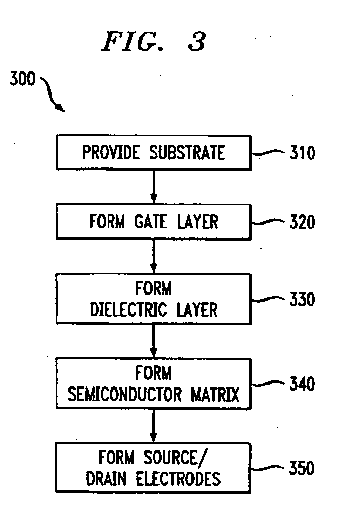

Another embodiment is a method of manufacture. The method of manufacture can be used to fabricate any of the above-described apparatuses. Fig. 3 presents a flow diagram showing selected steps in an exemplary method of manufacturing a device.

A substrate is provided in step 310. The substrate can include any conventional material, including the materials discussed above in the context of Figs 1-2. The substrate can also include device component layers such as a bottom gate 135 and dielectric layer 140 in the case of OFET devices 102, such as illustrated in Fig. 1. Alternatively the substrate can comprise a hole injection layer 215 and cathode 225 in the case of an OLED 202, as illustrated in Fig. 2. In some embodiments of the method, the substrate comprises glass upon which are successively formed, in step 320, a gate electrode comprising physical vapor deposited ITO, and an insulating layer, in step 330, comprising spin-coated PBMA. Alternatively, the substrate can comprise a silicon layer implanted with n- or p-type dopants, followed by a thermally grown SiO₂ dielectric layer, in steps 320 and 330, respectively.

In step 340, an organic semiconductor matrix is formed over the substrate. The matrix can be a thin film semiconductor layer in OFET devices or a light-emitting layer in OLED devices. The molecules can comprise any of the above-described embodiments of the compositions.

In some instances, forming the matrix comprises evaporating molecules of the organic semiconductor matrix onto the substrate. This is expected to be the case when the molecules of the matrix do not have a solubilizing group. Preferred evaporating conditions include pressures of about 1 x 10⁻⁵ Torr or less. In some cases, organic semiconductor matrices formed via evaporation have thicknesses ranging from about 50 to about 100 nanometers.

In some preferred embodiments, forming the matrix comprises depositing a solution of the organic semiconductor matrix onto the substrate. This is expected to be the case when the molecules of the matrix do have a solubilizing group. Any number of conventional solution processing techniques can be used to deposit the solution. Examples include drop-casting, spin-casting, dip-coating or liquid-jet-printing.

In step 350, source and drain electrodes are formed on the organic semiconductor matrix using conventional procedures. In some cases, for example, gold source and drain electrodes are deposited on the layer using a shadow mask. Of course, alternative steps, well known to those of ordinary skill in the art, would be followed to deposit the anode and hole injection layers to form an OLED device such as illustrated in Fig. 2. Also, further steps, well-known to those skilled in the art, could be performed to form an operative device.

## Claims

1. A composition, comprising:
a polymer of a plurality of monomers, each monomer being pentacene or a substituted pentacene, and at least two of the monomers being covalently bonded to each other by a bridging subunit, **characterized in that** said bridging subunit comprises at least one electron-withdrawing group.

2. The composition of claim 1, wherein the polymer includes at least 10 of the monomers.

3. The composition of claim 1, wherein some of the monomers include a substituted pentacene, each substituted pentacene including a pentacene unit and an electron-withdrawing group chemically bonded to the pentacene unit.

4. An apparatus, comprising:
a substrate; and
a composition according to any of claims 1 to 3, said composition being located over the substrate.

5. The apparatus of claim 4, wherein the polymer includes at least 10 of the monomers.

6. The apparatus of claim 4, wherein the polymer has a lower oxidation rate than pentacene.

7. The apparatus of claim 4, wherein each of the monomers comprise one pentacenyl subunit that is covalently bonded to one of the bridging subunits, each bridging subunit comprising at least one electron-withdrawing group.

8. The apparatus of claim 4, wherein each of the monomers comprise one pentacenyl subunit that is covalently bonded to the bridging subunit, the bridging subunit having at least one solubilizing group.

9. A method of manufacture, comprising,
forming a composition over a substrate, said composition being as defined according to any of claims 1 to 3.

## Patentansprüche

1. Eine Zusammensetzung, umfassend:
Ein Polymer aus einer Vielzahl von Monomeren, wobei jedes Monomer Pentacen oder ein substituiertes Pentacen ist, und mindestens zwei der Monomere über eine verbrückende Untereinheit kovalent aneinander gebunden sind, **dadurch gekennzeichnet, dass** die besagte verbrückende Untereinheit mindestens eine elektronenfangende Gruppe umfasst.

2. Die Zusammensetzung nach Anspruch 1, wobei das Polymer mindestens 10 der Monomere umfasst.

3. Die Zusammensetzung nach Anspruch 1, wobei einige der Monomere ein substituiertes Pentacen umfassen, wobei jedes substituierte Pentacen eine Pentaceneinheit und eine chemisch an die Pentaceneinheit gebundene elektronenfangende Gruppe umfasst.

4. Ein Apparat, umfassend:
Ein Substrat; und
eine Zusammensetzung nach einem der Ansprüche 1 bis 3, wobei die besagte Zusammensetzung über dem Substrat angebracht ist.

5. Der Apparat nach Anspruch 4, wobei das Polymer mindestens 10 der Monomere umfasst.

6. Der Apparat nach Anspruch 4, wobei das Polymer eine niedrigere Oxidationsrate als Pentacen aufweist.

7. Der Apparat nach Anspruch 4, wobei ein jedes der Monomere eine Pentacenyl-Untereinheit umfasst, welche kovalent an eine der verbrückenden Untereinheiten gebunden ist, wobei jede verbrückende Untereinheit mindestens eine elektronenfangende Gruppe umfasst.

8. Der Apparat nach Anspruch 4, wobei ein jedes der Monomere eine Pentacenyl-Untereinheit umfasst, welche kovalent an die verbrückende Untereinheit gebunden ist, wobei die verbrückende Untereinheit mindestens eine löslichmachende Gruppe hat.

9. Ein Herstellungsverfahren, umfassend:
Das Bilden einer Zusammensetzung über einem Substrat, wobei die besagte Zusammensetzung einem der Ansprüche 1 bis 3 entspricht.

## Revendications

1. Composition, comprenant :
un polymère constitué d'une pluralité de monomères, chaque monomère étant du pentacène ou du pentacène substitué, et au moins deux des monomères étant liés l'un à l'autre par liaison covalente d'un protomère de pontage, **caractérisée en ce que** ledit protomère de pontage comprend au moins un groupe de retrait d'électrons.

2. Composition selon la revendication 1, dans laquelle le polymère comprend au moins 10 des monomères.

3. Composition selon la revendication 1, dans laquelle certains des monomères comprennent un pentacène substitué, chaque pentacène substitué comprenant une unité de pentacène et un groupe de retrait d'électrons chimiquement lié à l'unité de pentacène.

4. Appareil, comprenant :
un substrat ; et
une composition selon l'une quelconque des revendications 1 à 3, ladite composition étant située sur le substrat.

5. Appareil selon la revendication 4, dans lequel le polymère comprend au moins 10 des monomères.

6. Appareil selon la revendication 4, dans lequel le polymère a un taux d'oxydation inférieur à celui du pentacène.

7. Appareil selon la revendication 4, dans lequel chacun des monomères comprend un protomère de pentacényle qui est lié par liaison covalente avec l'un des protomères de pontage, chaque protomère de pontage comprenant au moins un groupe de retrait d'électrons.

8. Appareil selon la revendication 4, dans lequel chacun des monomères comprend un protomère de pentacényle qui est lié par liaison covalente avec le protomère de pontage, le protomère de pontage comprenant au moins un groupe solubilisant.

9. Procédé de fabrication, comprenant :
la formation d'une composition sur un substrat, ladite composition étant telle que définie selon l'une quelconque des revendications 1 à 3.
